# EUROPÄISCHE PATENTSCHRIFT

(11) **EP 2 733 732 B1**
(45) Veröffentlichungstag und Bekanntmachung des Hinweises auf die Patenterteilung: **18.03.2020**
(21) Anmeldenummer: 13005309.3
(22) Anmeldetag: 11.11.2013
(51) Int. Cl.: H01L 21/67, H01L 21/68, H01L 21/687

(54) **Verfahren und Vorrichtung zur Inspektion von Wafern**
Method and device for inspecting wafers
Procédé et dispositifs destinés à l'inspection de tranches de silicium

(30) Priorität: 16.11.2012 DE 102012022502
(43) Veröffentlichungstag der Anmeldung: 21.05.2014
(73) Patentinhaber: MUETEC Automatisierte Mikroskopie und Messtechnik GmbH, 80992 München (DE)
(72) Erfinder: Scheuring, Gerd, 80992 München (DE); Ammerl, Josef, 94130 Obernzell (DE)
(74) Vertreter: Paustian, Othmar

(56) Entgegenhaltungen:
- WO-A1-2011/006687
- JP-A- H0 357 974
- JP-A- 2012 149 985
- US-A- 5 691 764

## Beschreibung

Die Erfindung bezieht sich auf ein Verfahren zur Inspektion von Wafern und auf eine Vorrichtung zur Durchführung des Verfahrens. Insbesondere bezieht sich die Erfindung auf ein automatisiertes Messen für die optische Kontrolle von Wafern in der Halbleiterfertigung. Wafer werden inspiziert, um fehlerhafte Wafer zu erkennen, insbesondere während ihrer und/oder im Anschluss an ihre Herstellung. Üblicherweise erfolgt die Inspektion mittels eines Scanners, der die Wafer abtastet. Es sind Inspektionseinrichtungen bekannt, die einen Scanner aufweisen, dem mittels einer Transporteinrichtung ein Wafer zugeführt wird, wobei die Transporteinrichtung eine Wafer-Aufnahme - auch als Chuck bezeichnet - aufweist, in der der zu inspizierende Wafer platziert ist. Zum Inspizieren des Wafers scannt der Scanner eine Seite des Wafers. Danach wird der Wafer gewendet oder einer weiteren Inspektionseinrichtung zugeführt, um die andere Waferseite zu scannen. Es sind auch Inspektionseinrichtungen mit zwei Scannern bekannt, die die beiden Waferseiten, d. h. die Front- und die Backside bzw. Vorder- und Rückseite, parallel scannen.

Um die Ausnutzung der Scanner zu erhöhen, ist es auch bekannt, eine Wafer-Aufnahme durch zwei Handling-Systeme zu bestücken, so dass der Zeitverlust beim Tauschen des Wafers in der Wafer-Aufnahme reduziert wird. Soll der Durchsatz weiter erhöht werden, müssen mehrere Inspektionseinrichtungen parallel eingesetzt werden.

Aus der US 5 691 764 A ist eine Inspektionseinrichtung bekannt, die zwei Schlitten auf einem gemeinsamen Durchlaufweg bewegt.

Aus der WO 2009/079565 A2 ist eine Inspektionseinrichtung bekannt, die einen Schlitten mit zwei nebeneinander liegenden Wafer-Aufnahmen aufweist. Mittels zweier voneinander getrennter Roboter, die auf zwei voneinander getrennte Lagereinrichtungen zugreifen, werden den beiden nebeneinander liegenden Wafer-Aufnahmen Wafer zugeführt und wieder aus diesen entfernt. Der Schlitten mit den beiden Wafer-Aufnahmen und der Scanner sind relativ zueinander bewegbar, um den Durchsatz zu verbessern.

Der Erfindung liegt die Aufgabe zugrunde, ein Verfahren und eine Vorrichtung vorzuschlagen, mit dem/der Wafer effizienter inspiziert werden können und der Durchsatz weiter erhöht werden kann.

Erfindungsgemäß wird diese Aufgabe mit einem Verfahren gemäß Anspruch 1 und einer Vorrichtung gemäß Anspruch 9 gelöst.

Durch die erfindungsgemäßen Maßnahmen können die Nutzzeiten der Inspektionseinrichtung bzw. des Scanners deutlich erhöht und gleichzeitig der technische Aufwand für das Inspizieren erheblich gesenkt werden. Erfindungsgemäß werden die Wafer der Inspektionseinrichtung abwechselnd aus entgegengesetzten Richtungen von jeweils einer Transporteinrichtung zugeführt. Dabei wird ein Wafer von ein und derselben Transporteinrichtung der einen Seite der Inspektionseinrichtung zugeführt, durch diese hindurch- und durch diese in entgegengesetzter Richtung auch wieder zurückgeführt, wobei hinter dem zurückgeführten Wafer von der anderen Transporteinrichtung ein anderer Wafer der anderen Seite der Inspektionseinrichtung zugeführt, durch diese hindurch- und durch diese in entgegengesetzter Richtung auch wieder zurückgeführt wird. Auf diese Weise kann, sobald ein inspizierter Wafer die Inspektionseinrichtung verlässt, dieser sofort ein anderer zu inspizierender Wafer zugeführt werden. Die Leerlaufzeiten der Inspektionseinrichtung werden so minimiert, wobei aufwendige Übergabe/Übernahmemechanismen an der Inspektionseinrichtung und/oder viel Platz beanspruchende Wegführungen für den Wafer vermieden werden. Da zudem die Transporteinrichtungen selbst die Wafer jeweils an einer Entnahmestation übernehmen und an eine Abnahmestation übergeben, können hier zusätzliche Einrichtungen, wie z. B. ein Roboter mit komplizierten Bewegungsabläufen, der einen zu inspizierenden Wafer von der Entnahmestation zu der Wafer-Aufnahme bringt, mit der der Wafer durch die Inspektionseinrichtung hindurchgeführt wird, und der nach der Inspektion den Wafer von der Wafer-Aufnahme zur Abnahmestation bringt, entfallen. Da solche Einrichtungen nicht mehr gebraucht werden, entfällt auch der entsprechende Platzbedarf und wird die Anzahl der Bauteile reduziert, was wiederum die Fertigungs- und Montagekosten senkt. Zudem reduziert sich mit der Anzahl der Bauteile auch die Störanfälligkeit des gesamten Inspektionsvorganges.

Vorzugsweise inspiziert die Inspektionseinrichtung in dem ersten Betriebsmodus beim Durchlauf eines Wafers dessen Vorder- und Rückseite parallel vollständig und inspiziert in zumindest einem zweiten Betriebsmodus beim Durchlauf eines Wafers diesen nicht, wobei die Inspektionseinrichtung im ersten Betriebsmodus betrieben wird, wenn der erste Wafer über den Durchlaufweg bis zu einer ersten Umkehrposition nach dem zweiten Ende des Durchlaufweges oder der zweite Wafer über den Durchlaufweg bis zu einer zweiten Umkehrposition nach dem ersten Ende des Durchlaufweges geführt wird, und wobei die Inspektionseinrichtung bei dem Zurückführen der Wafer durch die Inspektionseinrichtung im ersten oder zweiten Betriebsmodus betrieben wird. Wenn in einem Durchlauf sowohl die Vorder- als auch die Rückseite eines Wafers vollständig inspiziert wird, steht das Inspektionsergebnis frühestmöglich fest, so dass ein eventuell fehlerhafter Wafer möglichst schnell entsorgt werden kann und den weiteren Inspektionsvorgang nicht belastet. Es ist jedoch auch denkbar, den Wafer bei seinem Zurückführen zur Kontrolle mit einem anderen Verfahren noch einmal zu inspizieren. So könnte derselbe Wafer beispielsweise bei einem Durchlauf mit Schräglicht (Dunkelfeldbeleuchtung) und bei dem anderen Durchlauf mit Koaxiallicht (Hellfeldbeleuchtung) inspiziert werden.

Wenn der Wafer beim Zurückführen nicht inspiziert werden soll, kann der inspizierte Wafer mit einer Geschwindigkeit durch die Inspektionseinrichtung zurückgeführt werden, die unabhängig ist von der Inspektions- bzw. Scangeschwindigkeit, so dass hier das Handling des Wafers in einem möglichst großem Zeitraum unabhängig vom unmittelbaren Inspizieren optimiert werden kann.

In günstiger Weiterbildung der Erfindung werden die zu inspizierenden ersten und zweiten Wafer, nachdem sie allgemein in jeweils einer Entnahmestation bereitgestellt wurden, unmittelbar vor dem bzw. für das Inspizieren auf einer ersten bzw. zweiten Warteposition in einem vorgegebenen lichten Abstand zum ersten bzw. zweiten Ende des Durchlaufweges bereitgestellt, wobei in dem lichten Abstand die Umkehrposition für den jeweils anderen Wafer angeordnet ist, so dass mit dem Zurückführen des auf der Umkehrposition befindlichen Wafers über den Durchlaufweg der auf der benachbarten Warteposition befindliche Wafer gleich anschließend zum Durchlaufweg hingeführt werden kann. Der Abstand zwischen dem bereits inspizierten und dem noch zu inspizierenden Wafer und damit der zeitliche Abstand zwischen den Inspektionen kann auf diese Weise minimiert werden, wodurch die Nutzzeiten der Inspektionseinrichtung bzw. des Scanners maximiert werden.

Vorteilhafterweise werden dabei die inspizierten Wafer über ihre jeweilige Warteposition zur Abnahmestation geführt. Dies ist von besonderem Vorteil, wenn auf der jeweiligen Warteposition die Wafer in die Abnahmestation abgegeben und/oder aus der zugehörigen Entnahmestation übernommen werden können. Die Transportwege und Transportzeiten werden auf diese Weise beträchtlich reduziert.

Bevorzugt werden die Wafer vor und nach ihrer Inspektion mit einer höheren Geschwindigkeit fortbewegt als während ihrer Inspektion. Mit dieser Maßnahme ist es möglich, während der Inspektionszeit für den einen Wafer den zuvor inspizierten Wafer zur Abnahmestation zu bringen und dort zu übergeben und aus der Entnahmestation einen neuen zu inspizierenden Wafer zu übernehmen und auf der zugehörigen Warteposition bereitzustellen, so dass ohne Zeitverlust der neue zu inspizierende Wafer hinter dem bereits inspizierten und dann wieder zurückgeführten Wafer zum Durchlaufweg hingeführt werden kann. Auf diese Weise ist sichergestellt, dass der kostenintensive Scanner das geschwindigkeitsbestimmende Bauteil ist und nicht der Transport zum Scanner oder von diesem weg.

Von Vorteil ist es, wenn das Bereitstellen der Wafer deren Übernehmen aus einer jeweiligen Entnahmestation umfasst. Dabei werden die Entnahme- und die Abnahmestation bevorzugt als eine gemeinsame Lagereinrichtung ausgebildet. Hierdurch kann der Transportweg von der Entnahmestation zur Umkehrposition und von der Umkehrposition zur Abnahmestation über die selbe Strecke verlaufen, nur in entgegengesetzten Richtungen. Der Platzbedarf sowie die Anzahl der Bauteile zur Ausbildung der Transportwege wird dadurch erheblich reduziert.

Dabei werden vorzugsweise für die ersten und die zweiten Wafer jeweils getrennte Lagereinrichtungen bereitgestellt. Der Zugriff der Transporteinrichtungen auf die Lagereinrichtungen kann auf diese Weise unabhängig voneinander erfolgen. Wartezeiten oder Kollisionen sind ausgeschlossen.

Die Erfindung wird nachfolgend anhand der Zeichnungen beispielshalber noch näher erläutert. Es zeigen:
- Figur 1: in einer Perspektivansicht ein Ausführungsbeispiel einer erfindungsgemäßen Vorrichtung, mit zwei eingesetzten Lagereinrichtungen mit Waferstapeln;
- Figur 2: die Vorrichtung aus Figur 1 zu Beginn eines erfindungsgemäßen Inspektionsverfahrens bei der Übernahme jeweils eines ersten und eines zweiten zu inspizierenden Wafers durch eine erste und eine zweite Transporteinrichtung;
- Figur 3: die Vorrichtung aus Figur 1 mit den übernommenen zu inspizierenden Wafern auf ihren Wartepositionen;
- Figur 4: die Vorrichtung aus Figur 1, wobei die erste Transporteinrichtung den ersten Wafer zur Inspektionseinrichtung führt;
- Figur 5: die Vorrichtung aus Figur 1, wobei der erste Wafer seine Umkehrposition erreicht hat;
- Figur 6: die Vorrichtung aus Figur 1, wobei die erste Transporteinrichtung den ersten Wafer durch die Inspektionseinrichtung zurückgeführt hat und die zweite Transporteinrichtung den zweiten zu inspizierenden Wafer zur Inspektionseinrichtung führt;
- Figur 7: die Vorrichtung aus Figur 1, wobei die erste Transporteinrichtung mit dem ersten inspizierten Wafer dessen Warteposition erreicht hat und die zweite Transporteinrichtung den zweiten zu inspizierenden Wafer durch die Inspektionseinrichtung führt;
- Figur 8: die Vorrichtung aus Figur 1, wobei der erste inspizierte Wafer an die erste Lagereinrichtung übergeben wird und der zweite zu inspizierende Wafer die Inspektionseinrichtung durchläuft;
- Figur 9: die Vorrichtung aus Figur 1, wobei die erste Transporteinrichtung den ersten zu inspizierenden Wafer an die erste Lagereinrichtung übergeben hat und der zweite zu inspizierende Wafer seine Umkehrposition erreicht hat;
- Figur 10: die Vorrichtung aus Figur 1, wobei die erste Lagereinrichtung in eine neue Position zur Übernahme eines weiteren ersten zu inspizierenden Wafers durch die erste Transporteinrichtung fährt und die zweite Transporteinrichtung den zweiten Wafer durch die Inspektionseinrichtung zurückführt;
- Figur 11: die Vorrichtung aus Figur 1, wobei die erste Transporteinrichtung einen weiteren zu inspizierenden ersten Wafer übernimmt und die zweite Transporteinrichtung den zweiten inspizierten Wafer an die zweite Lagereinrichtung übergibt.
- Figur 12: die Vorrichtung aus Figur 1, wobei die erste Transporteinrichtung einen ersten zu inspizierenden Wafer zur Inspektionseinrichtung führt und die zweite Lagereinrichtung in eine neue Position zur Übernahme eines weiteren zweiten zu inspizierenden Wafers durch die zweite Transporteinrichtung fährt;
- Figur 13: die Vorrichtung aus Figur 1, wobei die erste Transporteinrichtung einen ersten Wafer durch die Inspektionseinrichtung führt und die zweite Transporteinrichtung einen zweiten zu inspizierenden Wafer übernimmt; und
- Figur 14: die Vorrichtung aus Figur 1, wobei die erste Transporteinrichtung mit dem ersten Wafer die erste Umkehrposition erreicht hat und die zweite Transporteinrichtung mit einem zweiten zu inspizierenden Wafer auf der zweiten Warteposition ist.

Das in den Figuren dargestellte Ausführungsbeispiel einer erfindungsgemäßen Vorrichtung 1 weist eine Inspektionseinrichtung 2, eine erste und eine zweite Transporteinrichtung 3, 4 sowie eine (nicht dargestellte) Steuereinrichtung auf, die gemeinsam auf einem Gestell 5 montiert sind.

Die Inspektionseinrichtung 2 weist ein optisches System zur optischen Kontrolle von Wafern 6, 7 auf. Das optische System ist aus einer doppelten Scannerzeile 8 zur parallelen Vorder- und Rückseiteninspektion der Wafer 6, 7 gebildet. Die Scannerzeile 8 verläuft horizontal und weist zwei sich in Zeilenachse erstreckende Licht aussendende Flächen auf, die übereinander angeordnet und einander zugewandt sind, zueinander einen vorgegebenen Abstand aufweisen und zwischen sich einen schlitzförmigen Durchlaufweg 9 zum Durchlauf eines zu inspizierenden Wafers 6, 7 ausbilden. Die Durchlaufrichtung der Wafer 6, 7 ist quer zur Längserstreckung der Scannerzeile 8, d. h. quer zur Zeilenachse.

In Durchlaufrichtung sind beidseits der Inspektionseinrichtung 2 bzw. Scannerzeile 8 jeweils eine Lagereinrichtung 10, 11 für einen Stapel bzw. eine Horde von Wafern 6, 7 angeordnet. Die Lagereinrichtungen 10, 11 sitzen jeweils auf einer Halterung 12, 13, die unabhängig voneinander in Richtung der Stapelhöhe verfahrbar sind. Die Lagereinrichtungen 10, 11 weisen jeweils ein Gehäuse auf, das an 5 Seiten geschlossen und nur an einer Seite 14, 15 offen ist. Diese offene Seite 14, 15 ist der zugehörigen Transporteinrichtung 3, 4 zugewandt.

Die Transporteinrichtungen 3, 4 weisen jeweils eine Wafer-Aufnahme 16, 17, auch als Chuck bezeichnet, sowie einen Halteabschnitt 18, 19, an dem die Wafer-Aufnahme 16, 17 befestigt ist, sowie eine Führungsschiene 20, 21 auf, die sich in Durchlaufrichtung erstreckt und am Gestell 5 befestigt ist.

Die Wafer 6, 7 sind in der Lagereinrichtung 10, 11 und in der Wafer-Aufnahme 16, 17 horizontal ausgerichtet und werden horizontal durch den Durchlaufweg 9 der Inspektionseinrichtung 2 geführt.

Die Wafer-Aufnahmen 16, 17 sind im dargestellten Ausführungsbeispiel jeweils eine horizontal ausgerichtete Scheibe mit einer Durchgangsöffnung 22, 23, deren Wandung eine Auflage 24, 25 ausbildet, auf der ein Wafer 6, 7 in seinem Randbereich aufliegen kann. Die Scheiben sind jeweils an einem ihrer Seitenränder 26, 27 an dem Halteabschnitt 18, 19 befestigt und ragen von dort aus frei bis zu einem vorgegebenen Abstand zur offenen Seite 14, 15 der zugehörigen Lagereinrichtung 10, 11 vor.

Der Halteabschnitt 18, 19 ist auf der Führungsschiene 20, 21 gleitend gelagert und längs dieser verfahrbar.

Die Führungsschiene 20, 21 erstreckt sich von der Lagereinrichtung 10, 11 auf der einen Seite der Scannerzeile 8 vorbei an einem 28 von deren Enden soweit über die Scannerzeile 8 bzw. Inspektionseinrichtung 2 hinaus, dass der inspizierte bzw. durchgelaufene Wafer 6, 7 ausreichend Platz auf der anderen Seite der Inspektionseinrichtung 2 findet.

Beide Führungsschienen 20, 21 sind am selben Ende 28 der Scannerzeile 8 angeordnet. Sie verlaufen übereinander und weisen zu diesem Ende 28 der Scannerzeile 8 einen vorgegebenen horizontalen Abstand 29 auf.

Dieses Ende 28 der Scannerzeile 8 ist offen. Durch dieses offene Ende 28 erstreckt sich der am Halteabschnitt 18, 19 befestigte Randabschnitt 26, 27 der Wafer-Aufnahme 16, 17 während deren Durchlauf durch die Scannerzeile 8, wobei sich der Halteabschnitt 18, 19 dann in dem Abstand bzw. Freiraum 29 zwischen Führungsschiene 20, 21 und offenen Ende 28 der Scannerzeile 8 befindet.

Auf diese Weise ist der Halteabschnitt 18, 19 mit der Wafer-Aufnahme 16, 17 von einer Position vor der zugehörigen Lagereinrichtung 10, 11 durch die Scannerzeile 8 hindurch bis zu einer Position auf der anderen Seite der Inspektionseinrichtung 2 und wieder zurück verfahrbar.

Der Transportweg der ersten Transporteinrichtung 3 führt somit von einer ersten Warteposition 30, die im dargestellten Ausführungsbeispiel vor einer ersten 10 der Lagereinrichtungen angeordnet ist, zu einem ersten Ende 32 des Durchlaufweges 9 der Inspektionseinrichtung 2 und durch diese hindurch zu einer ersten Umkehrposition 34 nach dem zweiten Ende 33 des Durchlaufweges 9 - d. h. auf der anderen Seite der Inspektionseinrichtung 2 bzw. Scannerzeile 8 - und wieder zurück durch die Inspektionseinrichtung 2 hindurch bis zur ersten Warteposition 30 vor der ersten Lagereinrichtung 10.

In ähnlicher Weise führt der Transportweg der zweiten Transporteinrichtung 4 von einer zweiten Warteposition 31 vor der zweiten Lagereinrichtung 11 zum zweiten Ende 33 des Durchlaufweges 9 an der Inspektionseinrichtung 2 und dann weiter durch diese hindurch bis zu einer zweiten Umkehrposition 35 nach dem ersten Ende 32 des Durchlaufweges 9 auf der anderen Seite der Inspektionseinrichtung 2, auf der die erste Lagereinrichtung 10 angeordnet ist. Danach führt der Transportweg der zweiten Transporteinrichtung 4 zurück über den Durchlaufweg 9 durch die Inspektionseinrichtung 2 zur zweiten Warteposition 31 vor der zweiten Lagereinrichtung 11.

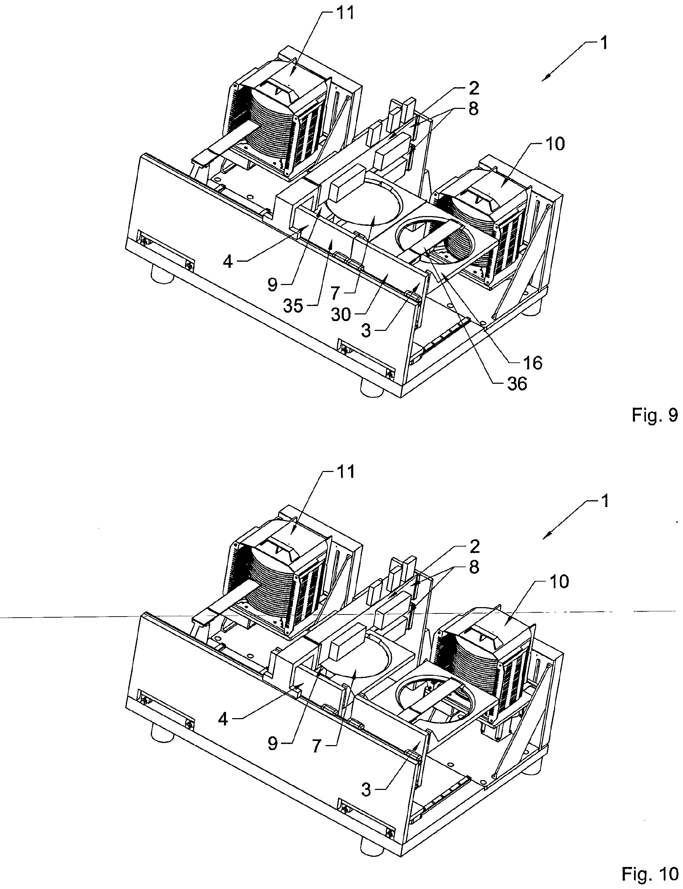

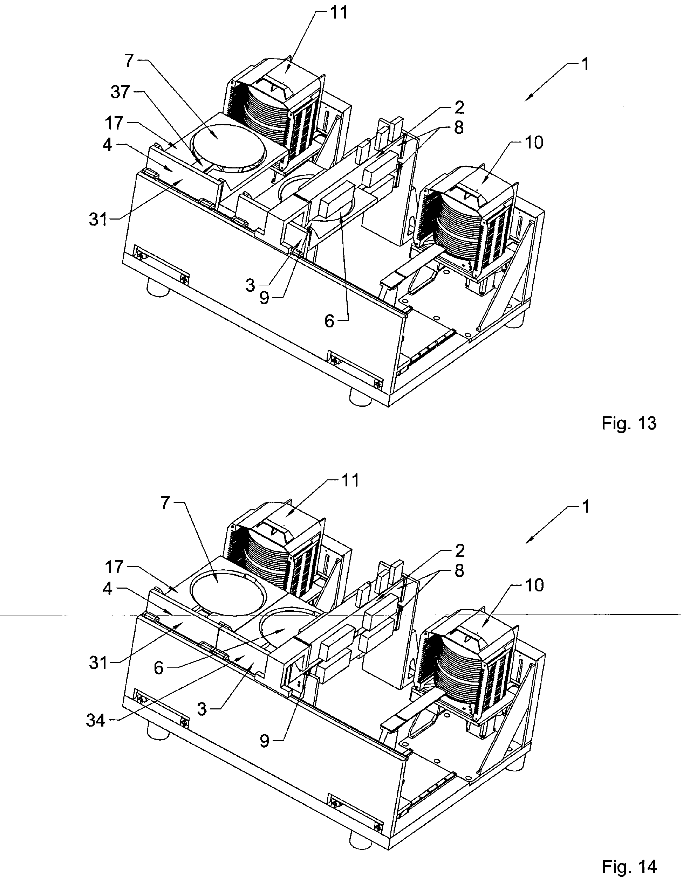

Im dargestellten Ausführungsbeispiel liegen die beiden Wafer-Aufnahmen in der Warteposition des einen Wafers und der Umkehrposition des anderen Wafers unmittelbar aneinander an (Figuren 9 und 14).

Jede Transporteinrichtung 3, 4 weist einen Auszugfinger 36, 37 auf, der dazu eingerichtet ist, einen zu inspizierenden Wafer 6, 7 aus der Lagereinrichtung 10, 11 herauszuholen und in der Wafer-Aufnahme 16, 17 zu platzieren und nach der Inspektion umgekehrt den inspizierten Wafer 6, 7 aus der Wafer-Aufnahme 16, 17 herauszunehmen und in der Lagereinrichtung 10, 11 abzulegen.

Die Lagereinrichtung 10, 11 ist somit eine Entnahmestation 38, 39, aus der zu inspizierende Wafer 6, 7 entnommen und in die Wafer-Aufnahme 16, 17 übergeben werden, und auch eine Abnahmestation 40, 41, in die die inspizierten Wafer 6, 7 aus der Wafer-Aufnahme 16, 17 übergeben werden.

Zur Übernahme und zur Übergabe der Wafer 6, 7 aus der bzw. in die Lagereinrichtung 10, 11 ist die Wafer-Aufnahme 16, 17 mittig vor die offene Seite 14, 15 der Lagereinrichtung 10, 11 positioniert, so dass die Wafer 6, 7 jeweils lediglich senkrecht zur Durchlaufrichtung vom Auszugfinger 36, 37 verschoben werden müssen.

Die Auszugfinger 36, 37 sind hierfür jeweils auf einem Schlitten 42, 43 montiert, der senkrecht zur Durchlaufrichtung bzw. zur Längserstreckung der Führungsschienen 20, 21 verfahrbar ist.

Die Lagereinrichtungen 10, 11 sind in vertikaler Richtung, d. h. in Höhenrichtung der Wafer-Stapel, relativ zum Auszugfinger 36, 37 verfahrbar. Durch vertikales Verfahren der Lagereinrichtungen 10, 11 wird die Position des Auszugfingers 36, 37 längs der Höhe des Wafer-Stapels bestimmt, und damit die Position innerhalb des Wafer-Stapels, aus der entweder ein zu inspizierender Wafer 6, 7 entnommen oder in die ein inspizierter Wafer 6, 7 abgelegt werden soll.

Die (nicht dargestellte) Steuereinrichtung ist an die Inspektionseinrichtung 2 und die beiden Transporteinrichtungen 3, 4 sowie an die beiden Lagereinrichtungen 10, 11 angeschlossen und dazu eingerichtet, deren Betrieb zu steuern und insbesondere den Betrieb der beiden Transporteinrichtungen 3, 4 in der Weise zeitversetzt zu steuern, dass die eine Transporteinrichtung 3, 4 einen zu inspizierenden Wafer 6, 7 zum Durchlaufweg führt, während die andere Transporteinrichtung 4, 3 einen inspizierten Wafer 7, 6 wieder zurück über den Durchlaufweg 9 führt.

Die Inspektionseinrichtung 2 ist zumindest zwischen einem ersten Betriebsmodus und einem zweiten Betriebsmodus umschaltbar. Im ersten Betriebsmodus wird beim Durchlauf eines Wafers 6, 7 dessen Vorder- und Rückseite parallel vollständig inspiziert. Im zweiten Betriebsmodus wird ein Wafer 6, 7 bei dessen Durchlauf nicht inspiziert. Die Steuereinrichtung kann dabei so eingerichtet sein, dass sie die Inspektionseinrichtung 2 in ihren ersten Betriebsmodus schaltet, wenn die erste Transporteinrichtung 3 einen ersten Wafer 6 über den Durchlaufweg 9 von dessen ersten Ende 32 in Richtung dessen zweites Ende 33 transportiert, d. h. von der ersten Warteposition 30 zur ersten Umkehrposition 34 auf der anderen Seite der Inspektionseinrichtung 2 transportiert, was auch als Vorlauf des ersten Wafers 6 bezeichnet wird.

Weiter ist die Steuereinrichtung dazu eingerichtet, die Inspektionseinrichtung 2 in ihren ersten Betriebsmodus zu schalten, wenn die zweite Transporteinrichtung 4 einen zweiten Wafer 7 über den Durchlaufweg 9 von dessen zweiten Ende 33 in Richtung dessen erstes Ende 32 transportiert, d. h. von der zweiten Warteposition 31 zur zweiten Umkehrposition 35 bzw. während des Vorlaufs des zweiten Wafers 7.

Die Steuereinrichtung ist in diesen Fällen dazu eingerichtet, die Inspektionseinrichtung 2 ansonsten - insbesondere während der jeweiligen Rückläufe eines ersten und eines zweiten Wafers 6, 7 - in ihren zweiten Betriebsmodus zu schalten.

Es kann jedoch auch gewünscht sein, die Wafer 6, 7 auch während ihrer Rückäufe zu inspizieren, beispielsweise zur Kontrolle mit einem anderen Inspektionsverfahren als während des Vorlaufs. In diesem Fall ist die Steuereinrichtung dazu eingerichtet, die Inspektionseinrichtung 2 auch während der Rückläufe der Wafer 6, 7 in ihren ersten Betriebsmodus zu schalten.

Die beiden Transporteinrichtungen 3, 4 können jeweils in einem ersten Betriebsmodus mit geringerer Transportgeschwindigkeit und in einem zweiten Betriebsmodus mit höherer Transportgeschwindigkeit betrieben werden. Die Steuereinrichtung schaltet z. B. die erste Transporteinrichtung 3 in ihren ersten Betriebsmodus, wenn die erste Transporteinrichtung 3 einen Wafer 6 über den Durchlaufweg 9 - d. h. durch die Inspektionseinrichtung 2 - transportiert, und die zweite Transporteinrichtung 4 in ihren ersten Betriebsmodus, wenn die zweite Transporteinrichtung 4 einen Wafer 7 über den Durchlaufweg 9 transportiert. Ansonsten schaltet die Steuereinrichtung beide Transporteinrichtungen 3, 4 in ihren zweiten Betriebsmodus, d. h. die Transporteinrichtungen 3, 4 transportieren die Wafer 6, 7 mit möglichst hoher Geschwindigkeit, wenn diese nicht inspiziert bzw. gescannt werden.

Werden die Wafer 6, 7 bei einem Durchlauf gescannt und bei dem zweiten Durchlauf nicht, so schaltet die Steuereinrichtung die Transporteinrichtungen 3, 4 auch jeweils in ihren zweiten Betriebsmodus, wenn die Wafer 6, 7 beim Durchlauf durch die Inspektionseinrichtung 2 nicht inspiziert werden.

Anhand der in den Figuren dargestellten Vorrichtung 1 wird nun ein Ausführungsbeispiel für das erfindungsgemäße Verfahren beschrieben:
Mit der doppelten Scannerzeile 8 wird eine Inspektionseinrichtung 2 bereitgestellt, die einen Durchlaufweg 9 aufweist, der in beiden Richtungen von einer Wafer-Aufnahme 16, 17 mit einem Wafer 6, 7 durchlaufen werden kann. Beim Durchlauf des Wafers 6, 7 wird dessen Vorder- und/oder Rückseite gescannt. Insbesondere werden Vorder- und Rückseite eines Wafers 6, 7 in einem ersten Betriebsmodus während eines Durchlaufs parallel vollständig inspiziert und in einem zweiten Betriebsmodus während seines zweiten Durchlaufs (beispielsweise während seines Rücklaufs) nicht gescannt.

Die beiden Wafer-Lagereinrichtungen bzw. -Horden 10, 11 werden auf ihre Halterungen 12, 13 gesetzt und die Wafer-Aufnahmen 16, 17 in ihre Grundstellung vor der offenen Seite 14, 15 der Lagereinrichtungen 10, 11 bzw. Gehäuse gebracht.

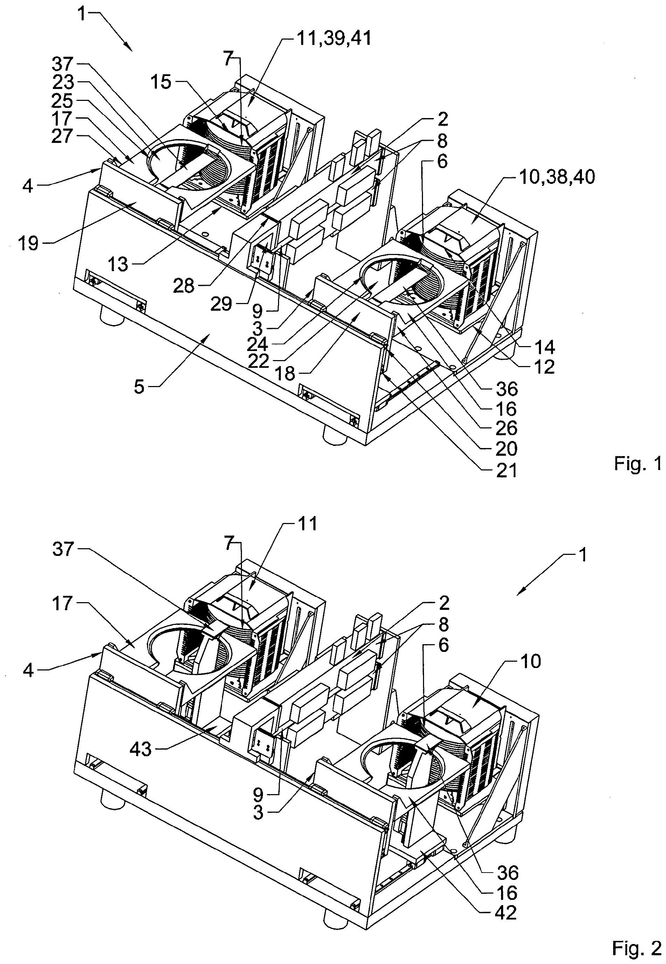

Die Lagereinrichtungen 10, 11 werden von einer oberen Position, in der sie auf ihre jeweilige Halterung 12, 13 aufgesetzt worden sind, in eine untere Position zur Entnahme von Wafern 6, 7 verfahren (Figur 1).

Zu Beginn des Verfahrens entnehmen die Auszugfinger 36, 37 beider Transporteinrichtungen 3, 4 gleichzeitig einen zu inspizierenden ersten bzw. zweiten Wafer 6, 7 aus den jeweiligen Lagereinrichtungen 10, 11 und legen ihn in die jeweilige Wafer-Aufnahme 16, 17 (Figur 2).

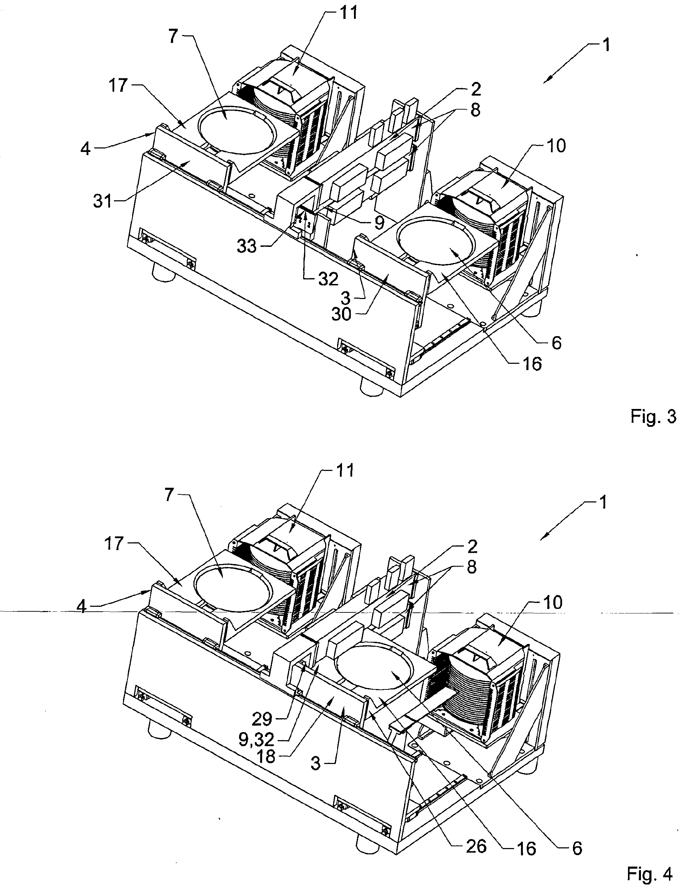

Beide Wafer 6, 7 befinden sich nun mit ihrem Wafer-Aufnahmen 16, 17 in ihren jeweiligen ersten bzw. zweiten Wartepositionen 30, 31 (Figur 3).

Dann wird die erste Wafer-Aufnahme 16 mit dem darin befindlichen ersten zu inspizierenden Wafer 6 zur Scannerzeile 8 gefahren (Figur 4), und dies mit der höchstmöglichen Geschwindigkeit, d. h. im zweiten Betriebsmodus der Transporteinrichtung 3 mit höherer Geschwindigkeit.

Bei Erreichen der Scannerzeile 8 wird diese in ihrem ersten Betriebsmodus und die erste Transporteinrichtung 3 ebenfalls in ihren ersten Betriebsmodus geschaltet, d. h. die Transportgeschwindigkeit wird verringert und der Wafer 6 über den Durchlaufweg 9 durch die Scannerzeile 8 geführt. Dabei werden die Ober- und Unterseite bzw. die Vorder- und Rückseite parallel vollständig gescannt.

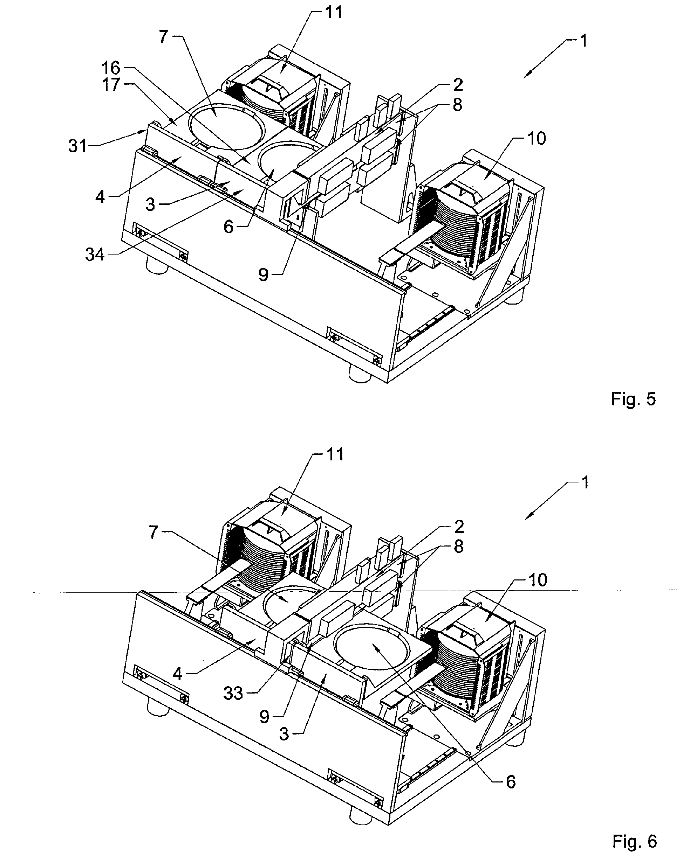

Die Wafer-Aufnahme 16 wird soweit über die Inspektionseinrichtung 2 hinausgeführt, bis der Wafer 6 den Durchlaufweg 9 vollständig durchlaufen hat und damit die Inspektion abgeschlossen ist. Der erste, nunmehr vollständig inspizierte Wafer 6 hat nun seine (erste) Umkehrposition 34 erreicht; die Wafer-Aufnahme 16 liegt zwischen der Inspektionseinrichtung 2 und der (zweiten) Warteposition 31 des zweiten zu inspizierenden Wafers 7. Die beiden Wafer-Aufnahmen 16, 17 liegen in dieser Stellung dicht beieinander (Figur 5) .

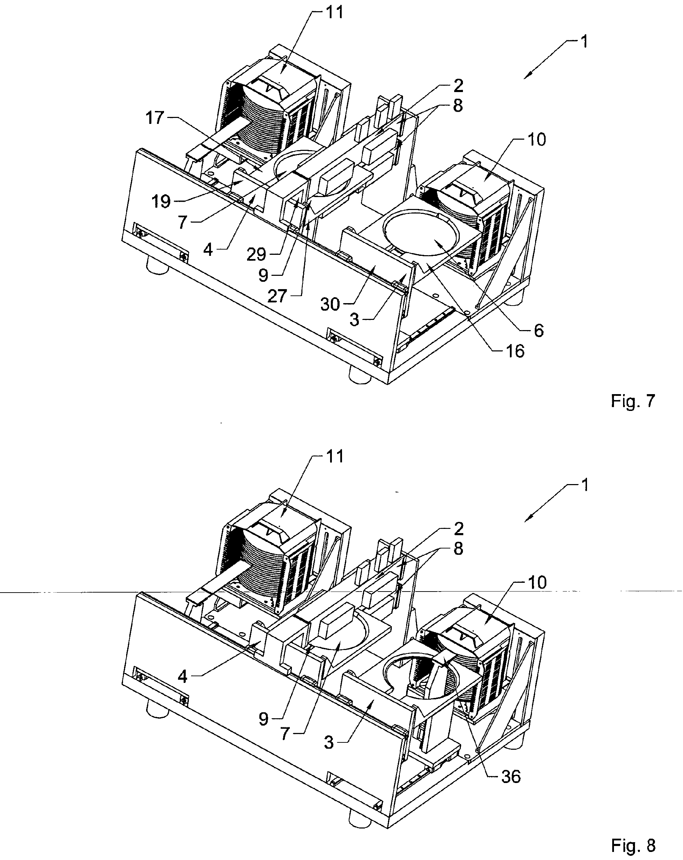

Nunmehr werden die Inspektionseinrichtung 2 und die erste Transporteinrichtung 3 jeweils in ihren zweiten Betriebsmodus geschaltet und der inspizierte erste Wafer 6 mit höherer Transportgeschwindigkeit - d. h. im Schnelllauf - durch die Scannerzeile 8 zurückgeführt bis zu seiner Warteposition 30 vor der ersten Lagereinrichtung 10 (Figuren 6 und 7). Der zweite zu inspizierende Wafer 7 wird nun zum zweiten Ende 33 des Durchlaufweges 9 geführt und über diesen durch die Scannerzeile 8 hindurch, wobei der zweite Wafer 7 bis zum Erreichen des Durchlaufweges 9 mit höchstmöglicher Transportgeschwindigkeit - d. h. im zweiten Betriebsmodus - und in der Scannerzeile 8 während des Scannens im ersten Betriebsmodus mit geringerer Geschwindigkeit transportiert wird. Sobald der zweite zu inspizierende Wafer 7 die Scannerzeile 8 erreicht, wird diese in ihren ersten Betriebsmodus geschaltet.

Während der zweite Wafer 7 gescannt wird, wird der erste inspizierte Wafer 6 mittels des Auszugfingers 36 der ersten Transporteinrichtung 3 in die erste Lagereinrichtung 10 übergeben (Figur 8).

Anschließend wird die erste Lagereinrichtung 10 auf eine neue Position verfahren, aus der der Auszugfinger 36 den nächsten ersten zu inspizierenden Wafer 6 entnehmen und in der Wafer-Aufnahme 16 der ersten Transporteinrichtung 3 platzieren soll (Figuren 9 und 10).

Wenn der zweite Wafer 7 den Durchlaufweg 9 durch die Scannerzeile 8 vollständig durchlaufen hat und somit die Vorder- und die Rückseite des Wafers 7 vollständig inspiziert ist, hat dieser Wafer 7 seine (zweite) Umkehrposition 35 erreicht (Figur 9). In dieser zweiten Umkehrposition 35 liegt der zweite inspizierte Wafer 7 zwischen der doppelten Scannerzeile 8 und der Wafer-Aufnahme 16 für den nächsten ersten zu inspizierenden Wafer 6, die auf der ersten Warteposition 30 liegt.

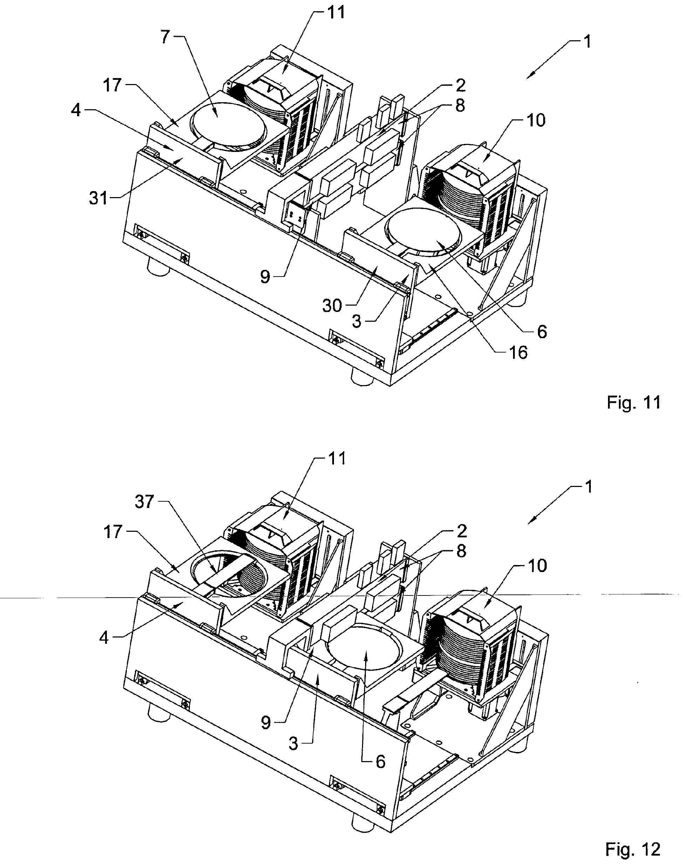

Der zweite inspizierte Wafer 7 wird nun mit hoher Geschwindigkeit im zweiten Betriebsmodus der Transporteinrichtung 4 durch die Scannerzeile 8, die nun ebenfalls wieder in ihren zweiten Betriebsmodus geschaltet ist, zurück auf seine zweite Warteposition 31 vor der zweiten Lagereinrichtung 11 zurücktransportiert und an diese übergeben. Währenddessen wird der nächste erste zu inspizierende Wafer 6 noch in der Wafer-Aufnahme 16 platziert (Figur 11) und danach mit hoher Geschwindigkeit im zweiten Betriebsmodus der ersten Transporteinrichtung 3 zur Scannerzeile 8 hintransportiert.

Wenn dieser nächste erste zu inspizierende Wafer 6 die Scannerzeile 8 erreicht hat (Figur 12), wird seine Transportgeschwindigkeit auf die des ersten Betriebsmodus der ersten Transporteinrichtung 3 verringert, die Scannerzeile 8 in ihren ersten Betriebsmodus geschaltet und der Wafer 6 über den Durchlaufweg 9 durch die Scannerzeile 8 hindurchgeführt, wobei die Vorder- und Rückseite des Wafers 6 vollständig parallel gescannt werden (Figur 13). Währenddessen wurde die zweite Lagereinrichtung 11 in eine neue Position gebracht, aus der der Auszugfinger 37 der zweiten Transporteinrichtung 4 den nächsten zweiten zu inspizierenden Wafer 7 entnehmen und auf der Wafer-Aufnahme 17 platzieren soll.

Wenn der nächste erste Wafer 6 den Durchlaufweg 9 vollständig durchlaufen hat und somit seine Inspektion abgeschlossen ist, befindet er sich auf der ersten Umkehrposition 34 zwischen dem nächsten zweiten zu inspizierenden Wafer 7, der auf seiner Warteposition 31 liegt, und der Inspektionseinrichtung 2 (Figur 14), was der in Figur 5 dargestellten Situation entspricht.

Die Vorgänge der Übernahme, des Transports zur Inspektionseinrichtung 2, der Inspektion, des Rücktransports und der Übergabe der ersten und zweiten Wafer 6, 7 wiederholen sich nun bis der letzte Wafer 6, 7 inspiziert ist.

Wenn das Übernehmen der zu inspizierenden Wafer 6, 7 und das Übergeben der inspizierten Wafer 6, 7 ausreichend schnell durchgeführt werden kann, bietet das erfindungsgemäße Verfahren und die erfindungsgemäße Vorrichtung 1 die Möglichkeit, die Scannerzeile 8 nahezu durchgehend zu nutzen. Da die Scannerzeile 8 das kostenintensivste Bauteil bei der Inspektion von Wafern 6, 7 ist, kann auf diese Weise die Waferinspektion kostenoptimiert werden.

## Patentansprüche

1. Verfahren zur Inspektion von Wafern (6, 7), mit den folgenden Schritten:
a) Bereitstellen einer Inspektionseinrichtung (2, 8), die einen Durchlaufweg (9) aufweist, der in beiden Richtungen von einem Wafer (6, 7) durchlaufen werden kann, und die in einem ersten Betriebsmodus beim Durchlauf eines Wafers (6, 7) dessen Vorder- und/oder Rückseite inspiziert;
b) Bereitstellen eines zu inspizierenden ersten Wafers (6);
c) Bereitstellen eines zu inspizierenden zweiten Wafers (7);
d) Führen des zu inspizierenden ersten Wafers (6) mittels einer ersten Transporteinrichtung (3) zu einem ersten Ende (32) des Durchlaufweges (9);
e) Führen des ersten Wafers (6) mittels der ersten Transporteinrichtung (3) über den Durchlaufweg (9) bis zu einer ersten Umkehrposition (34) nach dem zweiten Ende (33) des Durchlaufweges (9);
f) Führen des ersten Wafers (6) mittels der ersten Transporteinrichtung (3) zurück über den Durchlaufweg (9) und Führen des zu inspizierenden zweiten Wafers (7) mittels einer zweiten Transporteinrichtung (4) hinter dem ersten Wafer (6) zum zweiten Ende (33) des Durchlaufweges (9);
g) Führen des zweiten Wafers (7) mittels der zweiten Transporteinrichtung (4) über den Durchlaufweg (9) bis zu einer zweiten Umkehrposition (35) nach dem ersten Ende (32) des Durchlaufweges (9) und währenddessen Übergeben des inspizierten ersten Wafers (6) durch die erste Transporteinrichtung (3) an eine Abnahmestation (40) und Bereitstellen eines nächsten zu inspizierenden ersten Wafers (6);
h) Führen des zweiten Wafers (7) mittels der zweiten Transporteinrichtung (4) zurück über den Durchlaufweg (9) und Führen des zu inspizierenden ersten Wafers (6) mittels der ersten Transporteinrichtung (3) hinter dem zweiten Wafer (7) zum ersten Ende (32) des Durchlaufweges (9);
i) Führen des ersten Wafers (6) mittels der ersten Transporteinrichtung (3) über den Durchlaufweg (9) bis zu der ersten Umkehrposition (34) und währenddessen Übergeben des inspizierten zweiten Wafers (7) durch die zweite Transporteinrichtung (4) an eine Abnahmestation (41) und Bereitstellen eines nächsten zu inspizierenden zweiten Wafers (7);
j) Wiederholen der Schritte f) bis i).

2. Verfahren nach Anspruch 1,
**dadurch gekennzeichnet, dass**
im Schritt a) die Inspektionseinrichtung (2, 8) in dem ersten Betriebsmodus beim Durchlauf eines Wafers (6, 7) dessen Vorder- und Rückseite parallel vollständig inspiziert und in zumindest einem zweiten Betriebsmodus beim Durchlauf eines Wafers (6, 7) diesen nicht inspiziert;
in den Schritten e), g) und i) die Inspektionseinrichtung (2, 8) im ersten Betriebsmodus betrieben wird und
in den Schritten f) und h) die Inspektionseinrichtung (2, 8) im ersten oder zweiten Betriebsmodus betrieben wird.

3. Verfahren nach Anspruch 1 oder 2,
**dadurch gekennzeichnet, dass**
der Schritt b) das Bereitstellen eines zu inspizierenden ersten Wafers (6) auf einer ersten Warteposition (30) in einem vorgegebenen lichten Abstand zum ersten Ende (32) des Durchlaufweges (9) umfasst;
der Schritt c) das Bereitstellen eines zu inspizierenden zweiten Wafers (7) auf einer zweiten Warteposition (31) in einem vorgegebenen lichten Abstand zum zweiten Ende (33) des Durchlaufweges (9) umfasst;
der Schritt e) das Führen des ersten Wafers (6) über den Durchlaufweg (9) bis zu einer ersten Umkehrposition (34) zwischen dem zweiten Ende (33) des Durchlaufweges (9) und der zweiten Warteposition (35) umfasst;
der Schritt f) das Führen des zu inspizierenden zweiten Wafers (7) hinter dem ersten Wafer (6) von der zweiten Warteposition (31) zum zweiten Ende (33) des Durchlaufweges (9) umfasst; der Schritt g) das Führen des zweiten Wafers (7) über den Durchlaufweg (9) bis zu einer zweiten Umkehrposition (35) zwischen dem ersten Ende (32) des Durchlaufweges (9) und der ersten Warteposition (30) und das Bereitstellen eines nächsten zu inspizierenden ersten Wafers (6) auf der ersten Warteposition (30) spätestens zu dem Zeitpunkt, an dem der zweite Wafer (7) die zweite Umkehrposition (35) erreicht, umfasst;
der Schritt h) das Führen des zu inspizierenden ersten Wafers (6) hinter dem zweiten Wafer (7) von der ersten Warteposition (30) zum ersten Ende (32) des Durchlaufweges (9) umfasst; und
der Schritt i) das Bereitstellen eines nächsten zu inspizierenden zweiten Wafers (7) auf der zweiten Warteposition (31) spätestens zu dem Zeitpunkt, an dem der erste Wafer (6) die erste Umkehrposition (34) erreicht, umfasst.

4. Verfahren nach Anspruch 3,
**dadurch gekennzeichnet, dass**
die inspizierten Wafer (6, 7) über ihre jeweilige Warteposition (30, 31) zur Abnahmestation (40, 41) geführt werden.

5. Verfahren nach einem der vorhergehenden Ansprüche,
**dadurch gekennzeichnet, dass**
die Wafer (6, 7) vor und nach ihrer Inspektion mit einer höheren Geschwindigkeit fortbewegt werden als während ihrer Inspektion.

6. Verfahren nach einem der vorhergehenden Ansprüche,
**dadurch gekennzeichnet, dass**
der Schritt b) das Übernehmen des ersten Wafers (6) aus einer Entnahmestation (38) und der Schritt c) das Übernehmen des zweiten Wafers (7) aus einer Entnahmestation (39) umfasst.

7. Verfahren nach Anspruch 6,
**dadurch gekennzeichnet, dass**
die Entnahme- und die Abnahmestation (38, 40; 39, 41) als eine gemeinsame Lagereinrichtung (10, 11) ausgebildet werden.

8. Verfahren nach Anspruch 7,
**dadurch gekennzeichnet, dass**
für die ersten und die zweiten Wafer (6, 7) jeweils getrennte Lagereinrichtungen (10, 11) bereitgestellt werden.

9. Vorrichtung zur Durchführung des Verfahrens nach einem der Ansprüche 1 bis 8, mit einer Inspektionseinrichtung (2, 8), die einen Durchlaufweg (9) aufweist, der in beiden Richtungen von einem Wafer (6, 7) durchlaufen werden kann, und die in einem ersten Betriebsmodus beim Durchlauf eines Wafers (6, 7) dessen Vorder- und/oder Rückseite inspiziert,
einer ersten Transporteinrichtung (3), die dazu eingerichtet ist, einen zu inspizierenden Wafer (6) aus einer Entnahmestation (38) zu übernehmen und über einen Transportweg zu transportieren, der zu einem ersten Ende (32) des Durchlaufweges (9), weiter über diesen (9) selbst bis zu einer ersten Umkehrposition (34) nach dem zweiten Ende (33) des Durchlaufweges (9) und wieder zurück über den Durchlaufweg (9) bis zu einer Abnahmestation (40) führt, und den inspizierten Wafer (6) an diese (40) zu übergeben,
einer zweiten Transporteinrichtung (4), die dazu eingerichtet ist, einen zu inspizierenden Wafer (7) aus einer Entnahmestation (39) zu übernehmen und über einen Transportweg zu transportieren, der zu dem zweiten Ende (33) des Durchlaufweges (9), weiter über diesen (9) selbst bis zu einer zweiten Umkehrposition (35) nach dem ersten Ende (32) des Durchlaufweges (9) und wieder zurück über den Durchlaufweg (9) bis zu einer Abnahmestation (41) führt, und den inspizierten Wafer (7) an diese (41) zu übergeben, und mit einer Steuereinrichtung, die an die Inspektionseinrichtung (2, 8) und die Transporteinrichtungen (3, 4) angeschlossen und zum Steuern eines in der Weise zeitversetzten Betriebes der Transporteinrichtungen (3, 4) eingerichtet ist, dass die eine Transporteinrichtung (3, 4) einen zu inspizierenden Wafer (6, 7) zum Durchlaufweg (9) führt, während die andere Transporteinrichtung (4, 3) einen Wafer (7, 6) wieder zurück über den Durchlaufweg (9) führt.

10. Vorrichtung nach Anspruch 9,
**dadurch gekennzeichnet, dass**
die Inspektionseinrichtung (2, 8) zwischen zumindest einem ersten Betriebsmodus, in dem sie beim Durchlauf eines Wafers (6, 7) dessen Vorder- und Rückseite parallel vollständig inspiziert, und einem zweiten Betriebsmodus umschaltbar ist, in dem sie beim Durchlauf eines Wafers (6, 7) diesen nicht inspiziert, und
die Steuereinrichtung dazu eingerichtet ist,
die Inspektionseinrichtung (2, 8) in ihren ersten Betriebsmodus zu schalten, wenn die erste Transporteinrichtung (3) einen Wafer (6) über den Durchlaufweg (9) von dessen ersten Ende (32) in Richtung dessen zweites Ende (33) transportiert,
die Inspektionseinrichtung (2, 8) in ihren ersten Betriebsmodus zu schalten, wenn die zweite Transporteinrichtung (4) einen Wafer (7) über den Durchlaufweg (9) von dessen zweiten Ende (33) in Richtung dessen erstes Ende (32) transportiert, und
im Übrigen die Inspektionseinrichtung (2, 8) in ihren zweiten Betriebsmodus zu schalten.

11. Vorrichtung nach Anspruch 9 oder 10,
**dadurch gekennzeichnet, dass**
der Transportweg der ersten Transporteinrichtung (3) über eine erste Warteposition (30) zum ersten Ende (32) des Durchlaufweges (9) führt und
der Transportweg der zweiten Transporteinrichtung (4) über eine zweite Warteposition (31) zum zweiten Ende (33) des Durchlaufweges (9) führt, wobei
die erste Umkehrposition (34) zwischen dem zweiten Ende (33) des Durchlaufweges (9) und der zweiten Warteposition (31) und die zweite Umkehrposition (35) zwischen dem ersten Ende (32) des Durchlaufweges (9) und der ersten Warteposition (30) angeordnet ist.

12. Vorrichtung nach Anspruch 11,
**dadurch gekennzeichnet, dass**
die Transportwege von dem Durchlaufweg (9) zur jeweiligen Abnahmestation (40, 41) über die jeweilige Warteposition (30, 31) führen.

13. Vorrichtung nach einem der Ansprüche 9 bis 12,
**dadurch gekennzeichnet, dass**
die beiden Transporteinrichtungen (3, 4) mindestens zwischen einem ersten und einem zweiten Betriebsmodus umschaltbar sind, wobei im zweiten Betriebsmodus die Transportgeschwindigkeit höher ist als im ersten Betriebsmodus, und
die Steuereinrichtung dazu eingerichtet ist,
die erste Transporteinrichtung (3) in ihren ersten Betriebsmodus zu schalten, wenn die erste Transporteinrichtung (3) einen Wafer (6) über den Durchlaufweg (9) transportiert, die zweite Transporteinrichtung (4) in ihren ersten Betriebsmodus zu schalten, wenn die zweite Transporteinrichtung (4) einen Wafer (7) über den Durchlaufweg (9) transportiert, und
im Übrigen die Transporteinrichtungen (3, 4) in ihren zweiten Betriebsmodus zu schalten.

14. Vorrichtung nach Anspruch 10 und 13,
**dadurch gekennzeichnet, dass**
die Steuereinrichtung dazu eingerichtet ist,
die erste Transporteinrichtung (3) in ihren ersten Betriebsmodus zu schalten, wenn die erste Transporteinrichtung (3) einen Wafer (6) über den Durchlaufweg (9) von dessen ersten Ende (32) in Richtung dessen zweites Ende (33) transportiert,
die zweite Transporteinrichtung (4) in ihren ersten Betriebsmodus zu schalten, wenn die zweite Transporteinrichtung (4) einen Wafer (7) über den Durchlaufweg (9) von dessen zweiten Ende (33) in Richtung dessen erstes Ende (32) transportiert, und im Übrigen die Transporteinrichtungen (3, 4) in ihren zweiten Betriebsmodus zu schalten.

15. Vorrichtung nach einem der Ansprüche 9 bis 14,
**gekennzeichnet durch**
eine Lagereinrichtung (10, 11), die sowohl die Entnahmestation (38, 39) als auch die Abnahmestation (40, 41) ausbildet.

16. Vorrichtung nach Anspruch 15,
**dadurch gekennzeichnet, dass**
der ersten Transporteinrichtung (3) eine erste Lagereinrichtung (10) und der zweiten Transporteinrichtung (4) eine zweite Lagereinrichtung (11) zugeordnet ist.

## Claims

1. A method for the inspection of wafers (6, 7), comprising the following steps:
a) providing an inspection device (2, 8) which includes a passageway (9) through which a wafer (6, 7) can pass in both directions, and which in a first operating mode inspects the front side and/or rear side of a wafer (6, 7) on passage of the same;
b) providing a first wafer (6) to be inspected;
c) providing a second wafer (7) to be inspected;
d) guiding the first wafer (6) to be inspected by means of a first transport device (3) to a first end (32) of the passageway (9);
e) guiding the first wafer (6) by means of the first transport device (3) along the passageway (9) up to a first reversing position (34) after the second end (33) of the passageway (9);
f) guiding the first wafer (6) by means of the first transport device (3) back along the passageway (9) and guiding the second wafer (7) to be inspected by means of a second transport device (4) behind the first wafer (6) to the second end (33) of the passageway (9);
g) guiding the second wafer (7) by means of the second transport device (4) along the passageway (9) up to a second reversing position (35) after the first end (32) of the passageway (9) and meanwhile handing over the inspected first wafer (6) by the first transport device (3) to a take-off station (40) and providing a next first wafer (6) to be inspected;
h) guiding the second wafer (7) by means of the second transport device (4) back along the passageway (9) and guiding the first wafer (6) to be inspected by means of the first transport device (3) behind the second wafer (7) to the first end (32) of the passageway (9);
i) guiding the first wafer (6) by means of the first transport device (3) along the passageway (9) up to the first reversing position (34) and meanwhile handing over the inspected second wafer (7) by the second transport device (4) to a take-off station (41) and providing a next second wafer (7) to be inspected;
j) repeating the steps f) to i).

2. The method according to claim 1,
**characterized in that**
in step a) the inspection device (2, 8) in the first operating mode completely inspects the front and rear sides of a wafer (6, 7) in parallel on passage of the same, and in at least one second operating mode does not inspect a wafer (6, 7) on passage of the same;
in steps e), g) and i) the inspection device (2, 8) is operated in the first operating mode; and in steps f) and h) the inspection device (2, 8) is operated in the first or in the second operating mode.

3. The method according to claim 1 or 2,
**characterized in that**
step b) comprises providing a first wafer (6) to be inspected on a first waiting position (30) at a specified clear distance to the first end (32) of the passageway (9);
step c) comprises providing a second wafer (7) to be inspected on a second waiting position (31) at a specified clear distance to the second end (33) of the passageway (9);
step e) comprises guiding the first wafer (6) along the passageway (9) up to a first reversing position (34) between the second end (33) of the passageway (9) and the second waiting position (35);
step f) comprises guiding the second wafer (7) to be inspected behind the first wafer (6) from the second waiting position (31) to the second end (33) of the passageway (9);
step g) comprises guiding the second wafer (7) along the passageway (9) up to a second reversing position (35) between the first end (32) of the passageway (9) and the first waiting position (30) and providing a next first wafer (6) to be inspected on the first waiting position (30) at the latest by the time at which the second wafer (7) reaches the second reversing position (35);
step h) comprises guiding the first wafer (6) to be inspected behind the second wafer (7) from the first waiting position (30) to the first end (32) of the passageway (9); and
step i) comprises providing a next second wafer (7) to be inspected on the second waiting position (31) at the latest by the time at which the first wafer (6) reaches the first reversing position (34).

4. The method according to claim 3,
**characterized in that**
the inspected wafers (6, 7) are guided to the take-off station (40, 41) via their respective waiting position (30, 31).

5. The method according to any of the preceding claims,
**characterized in that**
before and after their inspection the wafers (6, 7) are moved on at a higher speed than during their inspection.

6. The method according to any of the preceding claims,
**characterized in that**
step b) comprises taking over the first wafer (6) from a withdrawal station (38), and
step c) comprises taking over the second wafer (7) from a withdrawal station (39).

7. The method according to claim 6,
**characterized in that**
the withdrawal station and the take-off station (38, 40; 39, 41) are configured as a common storage facility (10, 11).

8. The method according to claim 7,
**characterized in that**
for the first and the second wafers (6, 7) separate storage facilities (10, 11) each are provided.

9. An apparatus for carrying out the method according to any of claims 1 to 8, comprising an inspection device (2, 8) which includes a passageway (9) through which a wafer (6, 7) can pass in both directions, and which in a first operating mode inspects the front side and/or rear side of a wafer (6, 7) on passage of the same,
a first transport device (3) which is equipped to take over a wafer (6) to be inspected from a withdrawal station (38) and transport the same along a transport path, which leads to a first end (32) of the passageway (9), along the same (9) itself up to a first reversing position (34) after the second end (33) of the passageway (9) and back again along the passageway (9) up to a take-off station (40), and to hand over the inspected wafer (6) to the same (40), a second transport device (4) which is equipped to take over a wafer (7) to be inspected from a withdrawal station (39) and transport the same along a transport path which leads to the second end (33) of the passageway (9), along the same (9) itself up to a second reversing position (35) after the first end (32) of the passageway (9) and back again along the passageway (9) up to a take-off station (41), and to hand over the inspected wafer (7) to the same (41), and comprising a control device to which the inspection device (2, 8) and the transport devices (3, 4) are connected and which is equipped to control an operation of the transport devices (3, 4) offset in time such that the one transport device (3, 4) guides a wafer (6, 7) to be inspected to the passageway (9), while the other transport device (4, 3) leads a wafer (7, 6) back again along the passageway (9).

10. The apparatus according to claim 9,
**characterized in that**
the inspection device (2, 8) can be switched between at least one first operating mode, in which it completely inspects the front side and/or rear side of a wafer (6, 7) in parallel on passage of the same, and a second operating mode in which it does not inspect a wafer (6, 7) on passage of the same, and
the control device is equipped to
switch the inspection device (2, 8) into its first operating mode when the first transport device (3) transports a wafer (6) along the passageway (9) from its first end (32) in the direction of its second end (33),
switch the inspection device (2, 8) into its first operating mode when the second transport device (4) transports a wafer (7) along the passageway (9) from its second end (33) in the direction of its first end (32), and otherwise switch the inspection device (2, 8) into its second operating mode.

11. The apparatus according to claim 9 or 10,
**characterized in that**
the transport path of the first transport device (3) leads to the first end (32) of the passageway (9) via a first waiting position (30), and
the transport path of the second transport device (4) leads to the second end (33) of the passageway (9) via a second waiting position (31), wherein
the first reversing position (34) is arranged between the second end (33) of the passageway (9) and the second waiting position (31), and the second reversing position (35) is arranged between the first end (32) of the passageway (9) and the first waiting position (30).

12. The apparatus according to claim 11,
**characterized in that**
the transport paths extend from the passageway (9) to the respective take-off station (40, 41) via the respective waiting position (30, 31).

13. The apparatus according to any of claims 9 to 12,
**characterized in that**
the two transport devices (3, 4) can be switched at least between a first and a second operating mode, wherein in the second operating mode the transport speed is higher than in the first operating mode, and
the control device is equipped to
switch the first transport device (3) into its first operating mode when the first transport device (3) transports a wafer (6) along the passageway (9),
switch the second transport device (4) into its first operating mode when the second transport device (4) transports a wafer (7) along the passageway (9), and
otherwise switch the transport devices (3, 4) into their second operating mode.

14. The apparatus according to claims 10 and 13,
**characterized in that**
the control device is equipped to
switch the first transport device (3) into its first operating mode when the first transport device (3) transports a wafer (6) along the passageway (9) from its first end (32) in the direction of its second end (33),
switch the second transport device (4) into its first operating mode when the second transport device (4) transports a wafer (7) along the passageway (9) from its second end (33) in the direction of its first end (32), and
otherwise switch the transport devices (3, 4) into their second operating mode.

15. The apparatus according to any of claims 9 to 14,
**characterized by**
a storage facility (10, 11) which defines both the withdrawal station (38, 39) and the take-off station (40, 41).

16. The apparatus according to claim 15,
**characterized in that**
to the first transport device (3) a first storage facility (10) is associated, and to the second transport device (4) a second storage facility (11) is associated.

## Revendications

1. Procédé d'inspection de plaquettes (wafers) (6, 7), comprenant les étapes suivantes consistant à :
a) fournir un dispositif d'inspection (2, 8) qui présente un chemin de passage (9) à travers lequel une plaquette (6, 7) peut passer dans les deux directions et qui inspecte les faces avant et/ou arrière d'une plaquette (6, 7) lorsqu'elle passe à travers, dans un premier mode de fonctionnement ;
b) fournir une première plaquette à inspecter (6) ;
c) fournir une seconde plaquette à inspecter (7) ;
d) guider la première plaquette à inspecter (6) au moyen d'un premier dispositif de transport (3) vers une première extrémité (32) du chemin de passage (9) ;
e) guider la première plaquette (6) au moyen du premier dispositif de transport (3) sur le chemin de passage (9) jusqu'à une première position d'inversion (34) après la seconde extrémité (33) du chemin de passage (9) ;
f) guider la première plaquette (6) en retour sur le chemin de passage (9) au moyen du premier dispositif de transport (3) et guider la seconde plaquette à inspecter (7) vers la seconde extrémité (33) du chemin de passage (9) derrière la première plaquette (6) au moyen d'un second dispositif de transport (4) ;
g) guider la seconde plaquette (7) au moyen du second dispositif de transport (4) sur le chemin de passage (9) jusqu'à une seconde position d'inversion (35) après la première extrémité (32) du chemin de passage (9) et, pendant cela, remettre la première plaquette inspectée (6) au moyen du premier dispositif de transport (3) à une station de reprise (40) et fournir une première plaquette suivante à inspecter (6) ;
h) guider la seconde plaquette (7) en retour sur le chemin de passage (9) au moyen du second dispositif de transport (4) et guider la première plaquette à inspecter (6) au moyen du premier dispositif de transport (3) derrière la seconde plaquette (7) jusqu'à la première extrémité (32) du chemin de passage (9) ;
i) guider la première plaquette (6) au moyen du premier dispositif de transport (3) sur le chemin de passage (9) jusqu'à la première position d'inversion (34) et, pendant cela, remettre la seconde plaquette inspectée (7) par le second dispositif de transport (4) à une station de reprise (41) et fournir une seconde plaquette suivante à inspecter (7) ;
j) répéter les étapes f) à i).

2. Procédé selon la revendication 1,
**caractérisé en ce que**
dans l'étape a) le dispositif d'inspection (2, 8) dans le premier mode de fonctionnement inspecte complètement et en parallèle la face avant et la face arrière d'une plaquette (6, 7) lors de son passage et, dans au moins un second mode de fonctionnement, il n'inspecte pas la plaquette (6, 7) lors de son passage ;
dans les étapes e), g) et i), le dispositif d'inspection (2, 8) est utilisé dans le premier mode de fonctionnement ; et
dans les étapes (f) et (h), le dispositif d'inspection (2, 8) est utilisé dans le premier ou dans le second mode de fonctionnement.

3. Procédé selon la revendication 1 ou 2,
**caractérisé en ce que**
l'étape b) consiste à fournir une première plaquette à inspecter (6) à une première position d'attente (30) à une distance libre prédéterminée de la première extrémité (32) du chemin de passage (9) ;
l'étape c) consiste à fournir une seconde plaquette à inspecter (7) à une seconde position d'attente (31) à une distance libre prédéterminée de la seconde extrémité (33) du chemin de passage (9) ;
l'étape e) consiste à guider la première plaquette (6) sur le chemin de passage (9) jusqu'à une première position d'inversion (34) entre la seconde extrémité (33) du chemin de passage (9) et la seconde position d'attente (35) ;
l'étape f) consiste à guider la seconde plaquette à inspecter (7) derrière la première plaquette (6) depuis la seconde position d'attente (31) jusqu'à la seconde extrémité (33) du chemin de passage (9) ;
l'étape g) consiste à guider la seconde plaquette (7) sur le chemin de passage (9) jusqu'à une seconde position d'inversion (35) entre la première extrémité (32) du chemin de passage (9) et la première position d'attente (30) et à fournir une première plaquette suivante à inspecter (6) à la première position d'attente (30) au plus tard à l'instant auquel la seconde plaquette (7) atteint la seconde position d'inversion (35) ;
l'étape h) consiste à guider la première plaquette à inspecter (6) derrière la seconde plaquette (7) depuis la première position d'attente (30) jusqu'à la première extrémité (32) du chemin de passage (9) ;
et
l'étape i) consiste à fournir une seconde plaquette suivante à inspecter (7) à la seconde position d'attente (31) au plus tard à l'instant auquel la première plaquette (6) atteint la première position d'inversion (34).

4. Procédé selon la revendication 3,
**caractérisé en ce que**
les plaquettes inspectées (6, 7) sont guidées jusqu'à la station de reprise (40, 41) en passant par leur position d'attente respective (30, 31).

5. Procédé selon l'une des revendications précédentes,
**caractérisé en ce que**
avant et après leur inspection, les plaquettes (6, 7) sont déplacées à une vitesse supérieure à celle pendant leur inspection.

6. Procédé selon l'une des revendications précédentes,
**caractérisé en ce que**
l'étape b) consiste à reprendre la première plaquette (6) depuis une station de prélèvement (38) et l'étape c) consiste à reprendre la seconde plaquette (7) depuis une station de prélèvement (39).

7. Procédé selon la revendication 6,
**caractérisé en ce que**
les stations de prélèvement et de reprise (38, 40 ; 39, 41) sont réalisées sous la forme d'un dispositif de stockage commun (10, 11).

8. Procédé selon la revendication 7,
**caractérisé en ce que**
des dispositifs de stockage respectifs séparés (10, 11) sont prévus pour les premières et les secondes plaquettes (6, 7).

9. Dispositif pour mettre en oeuvre un procédé selon l'une des revendications 1 à 8, comportant
un dispositif d'inspection (2, 8) qui présente un chemin de passage (9) à travers lequel une plaquette (6, 7) peut passer dans les deux directions et qui inspecte les faces avant et/ou arrière d'une plaquette (6, 7) lorsqu'elle passe à travers, dans un premier mode de fonctionnement,
un premier dispositif de transport (3) qui est conçu pour reprendre une plaquette à inspecter (6) depuis une station de prélèvement (38) et pour la transporter sur un chemin de transport qui mène jusqu'à une première extrémité (32) du chemin de passage (9) en passant par ce dernier lui-même (9) jusqu'à une première position d'inversion (34) après la seconde extrémité (33) du chemin de passage (9) et en retour sur le chemin de passage (9) jusqu'à une station de reprise (40), et pour remettre la plaquette inspectée (6) à cette dernière (40),
un second dispositif de transport (4) qui est conçu pour reprendre une plaquette à inspecter (7) depuis une station de prélèvement (39) et pour la transporter sur un chemin de transport qui mène jusqu'à la seconde extrémité (33) du chemin de passage (9) en passant par ce dernier lui-même (9) jusqu'à une seconde position d'inversion (35) après la première extrémité (32) du chemin de passage (9) et en retour sur le chemin de passage (9) jusqu'à une station de reprise (41), et pour remettre la plaquette inspectée (7) à cette dernière (41), et
un dispositif de commande qui est connecté au dispositif d'inspection (2, 8) et aux dispositifs de transport (3, 4) et qui est conçu pour commander un fonctionnement des dispositifs de transport (3, 4) qui est décalé dans le temps de telle sorte que l'un des dispositifs de transport (3, 4) guide une plaquette à inspecter (6, 7) jusqu'au chemin de passage (9) pendant que l'autre dispositif de transport (4, 3) guide une plaquette (7, 6) en retour sur le chemin de passage (9).

10. Dispositif selon la revendication 9,
**caractérisé en ce que**
le dispositif d'inspection (2, 8) est commutable entre au moins un premier mode de fonctionnement dans lequel il inspecte complètement et en parallèle les faces avant et arrière d'une plaquette (6, 7) lorsqu'elle passe à travers, et un second mode de fonctionnement dans lequel il n'inspecte pas une plaquette (6, 7) lorsqu'elle passe à travers, et
le dispositif de commande est conçu pour
commuter le dispositif d'inspection (2, 8) dans son premier mode de fonctionnement lorsque le premier dispositif de transport (3) transporte une plaquette (6) sur le chemin de passage (9) depuis sa première extrémité (32) en direction de sa seconde extrémité (33), commuter le dispositif d'inspection (2, 8) dans son premier mode de fonctionnement lorsque le second dispositif de transport (4) transporte une plaquette (7) sur le chemin de passage (9) depuis sa seconde extrémité (33) en direction de sa première extrémité (32), et commuter par ailleurs le dispositif d'inspection (2, 8) dans son second mode de fonctionnement.

11. Dispositif selon la revendication 9 ou 10,
**caractérisé en ce que**
le chemin de transport du premier dispositif de transport (3) mène jusqu'à la première extrémité (32) du chemin de passage (9) en passant par une première position d'attente (30), et
le chemin de transport du second dispositif de transport (4) mène jusqu'à la seconde extrémité (33) du chemin de passage (9) en passant par une seconde position d'attente (31),
la première position d'inversion (34) étant disposée entre la seconde extrémité (33) du chemin de passage (9) et la seconde position d'attente (31), et la seconde position d'inversion (35) étant disposée entre la première extrémité (32) du chemin de passage (9) et la première position d'attente (30).

12. Dispositif selon la revendication 11,
**caractérisé en ce que**
les chemins de transport mènent depuis le chemin de passage (9) jusqu'à la station de reprise respective (40, 41) en passant par la position d'attente respective (30, 31).

13. Dispositif selon l'une des revendications 9 à 12,
**caractérisé en ce que**
les deux dispositifs de transport (3, 4) sont commutables au moins entre un premier et un second mode de fonctionnement, et dans le second mode de fonctionnement la vitesse de transport est supérieure à celle dans le premier mode de fonctionnement, et
le dispositif de commande est conçu pour
commuter le premier dispositif de transport (3) dans son premier mode de fonctionnement lorsque le premier dispositif de transport (3) transporte une plaquette (6) sur le chemin de passage (9),
commuter le second dispositif de transport (4) dans son premier mode de fonctionnement lorsque le second dispositif de transport (4) transporte une plaquette (7) sur le chemin de passage (9), et
commuter par ailleurs les dispositifs de transport (3, 4) dans leur second mode de fonctionnement.

14. Dispositif selon la revendication 10 et 13,
**caractérisé en ce que**
le dispositif de commande est conçu pour
commuter le premier dispositif de transport (3) dans son premier mode de fonctionnement lorsque le premier dispositif de transport (3) transporte une plaquette (6) sur le chemin de passage (9) depuis sa première extrémité (32) en direction de sa seconde extrémité (33),
commuter le second dispositif de transport (4) dans son premier mode de fonctionnement lorsque le second dispositif de transport (4) transporte une plaquette (7) sur le chemin de passage (9) depuis sa seconde extrémité (33) en direction de sa première extrémité (32), et
commuter par ailleurs les dispositifs de transport (3, 4) dans leur second mode de fonctionnement.

15. Dispositif selon l'une des revendications 9 à 14,
**caractérisé par**
un dispositif de stockage (10, 11) qui réalise aussi bien la station de prélèvement (38, 39) que la station de reprise (40, 41).

16. Dispositif selon la revendication 15,
**caractérisé en ce que**
un premier dispositif de stockage (10) est associé au premier dispositif de transport (3) et un second dispositif de stockage (11) est associé au second dispositif de transport (4).
